# EUROPEAN PATENT SPECIFICATION

(11) **EP 2 831 326 B1**
(45) Date of publication and mention of the grant of the patent: **19.10.2016**
(21) Application number: 13716660.9
(22) Date of filing: 29.03.2013
(51) Int. Cl.: C08L 79/08, D04H 1/541, D21H 21/34, D21H 25/04, D21H 13/26, D21H 17/00, H01B 3/52, H05K 1/03

(54) **ELECTRICAL INSULATION PAPER, METHODS OF MANUFACTURE, AND ARTICLES MANUFACTURED THEREFROM**
ELEKTROISOLIERPAPIER, HERSTELLUNGSVERFAHREN UND DARAUS HERGESTELLTE ARTIKEL
PAPIER D'ISOLATION ÉLECTRIQUE, PROCÉDÉS DE FABRICATION ET ARTICLES FABRIQUÉS À PARTIR DE CELUI-CI

(30) Priority: 30.03.2012 US 201261618014 P
(43) Date of publication of application: 04.02.2015
(73) Proprietor: SABIC Global Technologies B.V., 4612 PX Bergen op Zoom (NL)
(72) Inventor: CHOATE, Kim, R., Pittsfield, Massachusetts 01201 (US); KRAHN, John, Raymond, Niskayuna, New York 12309 (US); LOCKYER, Dennis, Pittsfield, Massachusetts 01201 (US); ADJEI, Thomas, Dalton, Massachusetts 01226 (US); TEUTSCH, Erich, Otto, Pittsfield, Massachusetts 01201 (US); DAVID, Benny Ezekiel, Great Berrington, Massachusetts 01230 (US)
(74) Representative: Office Freylinger
(86) International application number: PCT/US2013/034527
(87) International publication number: WO 2013/149105

(56) References cited:
- EP-A2- 0 217 563
- EP-A2- 1 243 696
- WO-A1-02/20698
- WO-A1-91/02042
- WO-A1-96/11293
- JP-A- 2004 241 647
- US-A- 5 514 748
- US-A- 5 729 423

## Description

### BACKGROUND

This disclosure relates to electrical insulation paper.

Various types of electrical machinery contain electrical insulation paper to non-conductively isolate charged components and electrical leads from non-charged components and housing elements. Electrical insulation papers are made primarily of one of two materials: cellulose or aramid fibers. Both of these materials have noticeable moisture up-take which has a negative effect on the electrical properties of the materials as well as the system-level performance of the insulation system. Consequently, extensive drying operations and manufacturing care need to be observed so that these materials stay sufficiently dry.

In addition, the cellulose papers have a limited thermal capability such that natural cellulose-based materials start showing significant long-term degradation during exposure to temperatures exceeding about 120°C. Moreover, the cellulose degradation mechanism is not only catalyzed by water, but also produces water as a by-product, which can result in a cascading cycle of auto-catalytic degradation.

On the other hand, aramid fiber papers such as Nomex are relatively costly and represent "thermal-overkill" for many of the applications in which they are used. For example, while most motors have Class-F (155°C) or Class-H (180°C) insulation systems, Nomex is rated up to Class R-(220)°C insulation. In such applications, the full thermal capability of the Nomex electrical insulation paper is not a design requirement and the Nomex can thus be viewed as an unnecessary excess cost.

There accordingly remains a need in the art for electrical grade insulation paper that has significantly less moisture up-take than cellulose and Nomex, and that are inexpensive to manufacture. It would be a further advantage if such fibers could operate at high temperature. There remains a further need for efficient methods for producing such electrical papers.

### SUMMARY

In one embodiment, a fibrous substrate is provided comprising the consolidated product of a fiber composition comprising 35 to 70 weight percent (wt.%) of polyetherimide fibers having a polydispersity index of 2.2 to 2.5 ; at least 5 wt.% of aromatic polyamide fibrids; 20 to 30 wt.% of liquid crystal polymer fibers, each based on the total weight of the fibers in the fiber composition; wherein the consolidated product has a thickness of from more than 0 to less than 200 µm.

In another embodiment, electrical insulation paper comprising the fibrous substrate is disclosed wherein the substrate comprises less than 10 wt.% of a polycarbonate fiber.

In a further embodiment, a process of preparing a fibrous substrate is provided, comprising forming a layer from a slurry comprising a suspension solvent; and a fiber composition comprising a combination of 35 to 70 wt.% of polyimide fibers; at least 5 wt.% of aromatic polyamide fibers; and 5 to 30 wt.% of liquid crystal polymer fibers, wherein the wt.% of the fibers is based on the total weight of the fibers in the fiber composition; dewatering the layer; and consolidating the layer to form the fibrous substrate.

In another embodiment, articles comprising the above fibrous substrates are provided.

### DETAILED DESCRIPTION OF THE INVENTION

The present inventors have discovered that moisture-resistant electrical grade fibrous substrates can be manufactured using a combination of polyetherimide fibers, liquid crystal polymer fibers, and aromatic polyamide fibrids. The paper is produced by mixing several different chopped, thermoplastic polymer fibers chosen to have melt temperatures differing sufficiently to permit consolidation, during which the primary polymer is pressed into a continuous film, while the reinforcing fiber polymer remains as un-melted fibers. In an embodiment, the consolidated substrates contain melted polyetherimide fibers which form a continuous or semi-continuous matrix, making a film-like structure within the paper.

The fibrous substrate can contain 35 to 70 wt.% of polyimide fibers, for example 40 to 70 wt.%, 50 to 70 wt.%, 40 to 65 wt.%, 45 to 65 wt.%, 50 to 65 wt.%, 50 to 70 wt.%, 60 to 70 wt.% or 65 to 70 wt.% of polyimide fibers.

The fibrous substrate can contain at least 5 wt.% of aromatic polyamide fibrids, for example 5 to 30 wt.%, 5 to 25 wt.%, 5 to 20 wt.%, 5 to 15 wt.%, 5 to 10 wt.%, 10 to 30 wt.%, 10 to 25 wt.%, 10 to 20 wt.%, or 10 to 15 wt.% of aromatic polyamide fibrids.

The fibrous substrate can contain 5 to 30 wt.% of liquid crystal polymer fibers, for example 5 to 25 wt.%, 5 to 20 wt.%, 5 to15 wt.%, 5 to 10 wt.%, 10 to 30 wt.%, 10 to 25 wt.%, 10 to 20 wt.%, 10 to 15 wt.%, 15 to 30 wt.%, 15 to 25 wt.%, 15 to 20 wt.%, 20 to 30 wt.%, 25 to 30 wt.% of liquid crystal polymer fibers.

The fibrous substrates can be thermally stable at high temperatures, have high mechanical strength and modulus, low creep, and/or good chemical stability.

The term "fibers" as used herein includes a wide variety of structures having a single filament with an aspect ratio (length : diameter) of greater than 2, specifically greater than 5, greater than 10, or greater than 100. The term fibers also includes fibrets (very short (length less than 1 mm), fine (diameter less than 50 micrometers (µm)) fibrillated fibers that are highly branched and irregular resulting in high surface area), and fibrils, tiny threadlike elements of a fiber. The diameter of a fiber is indicated by its fiber number, which is generally reported as either dtex or dpf. The numerical value reported as "dtex" indicates the mass in grams per 10,000 meters of the fiber. The numerical value "dpf" represents the denier per fiber. The denier system of measurement is used on two and single filament fibers, and dpf = Total Denier / Quantity of Uniform Filaments. Some common denier-related calculations are as follows:
1 denier = 1 gram per 9,000 meters = 0.05 grams per 450 meters = 0.111 milligrams per meter.
In practice, measuring 9,000 meters is cumbersome and usually a sample of 900 meters is weighed and the result multiplied by 10 to obtain the denier weight.

The term "fibrids", as used herein, means very small, nongranular, fibrous or film-like particles with at least one of their three dimensions being of minor magnitude relative to the largest dimension, such that they are essentially two-dimensional particles, typically having a length from greater than 0 to less than 0.3 mm, and a width of from greater than 0 to less than 0.3 mm and a depth of from greater than 0 to less than 0.1 mm. A specific size for the fibrids is 100 µm x 100 µm x 0.1 µm.

Fibrids are typically made by streaming a polymer solution into a coagulating bath of liquid that is immiscible with the solvent of the solution. The stream of polymer solution is subjected to strenuous shearing forces and turbulence as the polymer is coagulated. The fibrid material of this invention can be meta or para-aramid or blends thereof. More specifically, the fibrid is a para-aramid. Such aramid fibrids, before being dried, can be used wet and can be deposited as a binder physically entwined about the floc component of a paper.

Various numerical ranges are disclosed in this patent application. Because these ranges are continuous, they include every value between the minimum and maximum values. Unless expressly indicated otherwise, the various numerical ranges specified in this application are approximations. The endpoints of all ranges directed to the same component or property are inclusive of the endpoint and independently combinable.

The terms "a" and "an" do not denote a limitation of quantity, but rather denote the presence of at least one of the referenced item. As used herein, "combination thereof" is inclusive of one or more of the recited elements, optionally together with a like element not recited. Reference throughout the specification to "an embodiment," "another embodiment, "some embodiments," and so forth, means that a particular element (e.g., feature, structure, property, and/or characteristic) described in connection with the embodiment is included in at least an embodiment described herein, and may or may not be present in other embodiments. In addition, it is to be understood that the described element(s) can be combined in any suitable manner in the various embodiments.

Compounds are described using standard nomenclature. For example, any position not substituted by any indicated group is understood to have its valency filled by a bond as indicated, or a hydrogen atom. A dash ("-") that is not between two letters or symbols is used to indicate a point of attachment for a substituent. For example, -CHO is attached through carbon of the carbonyl group. The term "alkyl" includes both C1-30 branched and straight chain, unsaturated aliphatic hydrocarbon groups having the specified number of carbon atoms. Examples of alkyl include, but are not limited to, methyl, ethyl, n-propyl, i-propyl, n-butyl, s-butyl, t-butyl, n-pentyl, s-pentyl, n- and s-hexyl, n-and s-heptyl, and, n- and s-octyl. The term "aryl" means an aromatic moiety containing the specified number of carbon atoms and optionally 1 to 3 heteroatoms (e.g., O, S, P, N, or Si), such as to phenyl, tropone, indanyl, or naphthyl.

All molecular weights in this application refer to weight average molecular weights unless indicated otherwise. All such mentioned molecular weights are expressed in Daltons.

All ASTM tests are based on the 2003 edition of the Annual Book of ASTM Standards unless otherwise indicated.

Polyetherimides comprise more than 1, for example 10 to 1,000 or 10 to 500 structural units, of formula (1) 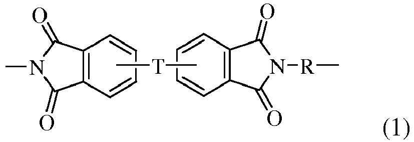 wherein each R is the same or different, and is a substituted or unsubstituted divalent organic group, such as a C₆₋₂₀ aromatic hydrocarbon group or a halogenated derivative thereof, a straight or branched chain C₂₋₂₀ alkylene group or a halogenated derivative thereof, a C₃₋₈ cycloalkylene group or halogenated derivative thereof, in particular a divalent group of formula (2) 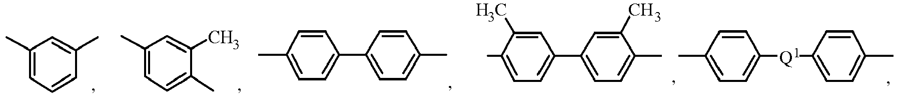 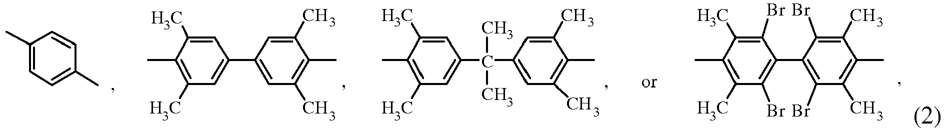 wherein Q¹ is -O-, -S-, -C(O)-, -SO₂-, -SO-, or -C_{y}H_{2y}- wherein y is an integer from 1 to 5 or a halogenated derivative thereof (which includes perfluoroalkylene groups). In an embodiment, R is m-phenylene or p-phenylene.

Further in formula (1), T is -O- or a group of the formula -O-Z-O- wherein the divalent bonds of the -O- or the -O-Z-O- group are in the 3,3', 3,4', 4,3', or the 4,4' positions. The group Z in formula (1) is the same or different, and is also a substituted or unsubstituted divalent organic group, and can be an aromatic C₆₋₂₄ monocyclic or polycyclic moiety optionally substituted with 1 to 6 C₁₋₈ alkyl groups, 1 to 8 halogen atoms, or a combination comprising at least one of the foregoing provided that the valence of Z is not exceeded. Exemplary groups Z include groups derived from a dihydroxy compound of formula (3): 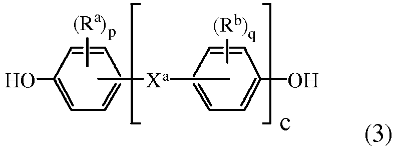 wherein R^{a} and R^{b} can be the same or different and are a halogen atom or a monovalent C₁₋₆ alkyl group, for example ; p and q are each independently integers of 0 to 4; c is 0 to 4; and X^{a} is a bridging group connecting the hydroxy-substituted aromatic groups, where the bridging group and the hydroxy substituent of each C₆ arylene group are disposed ortho, meta, or para (specifically para) to each other on the C₆ arylene group. The bridging group X^{a} can be a single bond, -O-, -S-, -S(O)-, -S(O)₂ -C(O)-, or a C₁₋₁₈ organic bridging group. The C₁₋₁₈ organic bridging group can be cyclic or acyclic, aromatic or non-aromatic, and can further comprise heteroatoms such as halogens, oxygen, nitrogen, sulfur, silicon, or phosphorous. The C₁₋₁₈ organic group can be disposed such that the C₆ arylene groups connected thereto are each connected to a common alkylidene carbon or to different carbons of the C₁₋₁₈ organic bridging group. A specific example of a group Z is a divalent group of formulas (3a) 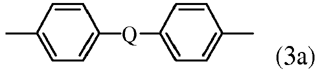 wherein Q is -O-, -S-, -C(O)-, -SO₂-, -SO-, or -C_{y}H_{2y}- wherein y is an integer from 1 to 5 or a halogenated derivative thereof (including a perfluoroalkylene group). In a specific embodiment, Z is derived from bisphenol A wherein Q in formula (3a) is 2,2-isopropylidene.

In an embodiment in formula (1), R is m-phenylene or p-phenylene and T is - O-Z-O wherein Z is a divalent group of formula (3a). Alternatively, R is m-phenylene or p-phenylene and T is -O-Z-O wherein Z is a divalent group of formula (3a) and Q is 2,2-isopropylidene.

In some embodiments, the polyetherimide can be a copolymer, for example, a polyetherimide sulfone copolymer comprising structural units of formula (1) wherein at least 50 mole % of the R groups are of formula (2) wherein Q¹ is -SO₂- and the remaining R groups are independently p-phenylene or m-phenylene or a combination comprising at least one of the foregoing; and Z is 2,2-(4-phenylene)isopropylidene. Alternatively, the polyetherimide optionally comprises additional structural imide units, for example imide units of formula (4) 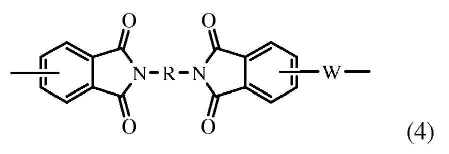 wherein R is as described in formula (1) and W is a linker of the formulas 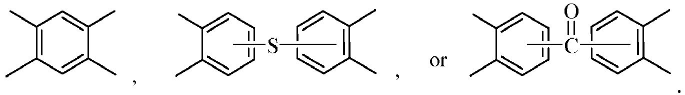 These additional structural imide units can be present in amounts from 0 to 10 mole % of the total number of units, specifically 0 to 5 mole %, more specifically 0 to 2 mole %. In an embodiment, no additional imide units are present in the polyetherimide.

The polyetherimide can be prepared by any of the methods well known to those skilled in the art, including the reaction of an aromatic bis(ether anhydride) of formula (5) 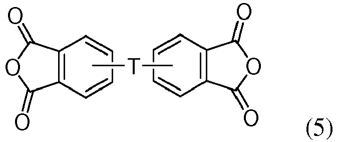 with an organic diamine of formula (6)

H₂N-R-NH₂ (6)

wherein T and R are defined as described above. Copolymers of the polyetherimides can be manufactured using a combination of an aromatic bis(ether anhydride) of formula (5) and a different bis(anhydride), for example a bis(anhydride) wherein T does not contain an ether functionality, for example T is a sulfone.

Illustrative examples of bis(anhydride)s include 3,3-bis[4-(3,4-dicarboxyphenoxy)phenyl]propane dianhydride; 4,4'-bis(3,4-dicarboxyphenoxy)diphenyl ether dianhydride; 4,4'-bis(3,4-dicarboxyphenoxy)diphenyl sulfide dianhydride; 4,4'-bis(3,4-dicarboxyphenoxy)benzophenone dianhydride; 4,4'-bis(3,4-dicarboxyphenoxy)diphenyl sulfone dianhydride; 2,2-bis[4-(2,3-dicarboxyphenoxy)phenyl]propane dianhydride; 4,4'-bis(2,3-dicarboxyphenoxy)diphenyl ether dianhydride; 4,4'-bis(2,3-dicarboxyphenoxy)diphenyl sulfide dianhydride; 4,4'-bis(2,3-dicarboxyphenoxy)benzophenone dianhydride; 4,4'-bis(2,3-dicarboxyphenoxy)diphenyl sulfone dianhydride; 4-(2,3-dicarboxyphenoxy)-4'-(3,4-dicarboxyphenoxy)diphenyl-2,2-propane dianhydride; 4-(2,3-dicarboxyphenoxy)-4'-(3,4-dicarboxyphenoxy)diphenyl ether dianhydride; 4-(2,3-dicarboxyphenoxy)-4'-(3,4-dicarboxyphenoxy)diphenyl sulfide dianhydride; 4-(2,3-dicarboxyphenoxy)-4'-(3,4-dicarboxyphenoxy)benzophenone dianhydride; and, 4-(2,3-dicarboxyphenoxy)-4'-(3,4-dicarboxyphenoxy)diphenyl sulfone dianhydride, as well as various combinations comprising at least one of the foregoing dianhydrides.

Examples of organic diamines include ethylenediamine, propylenediamine, trimethylenediamine, diethylenetriamine, triethylene tetramine, hexamethylenediamine, heptamethylenediamine, octamethylenediamine, nonamethylenediamine, decamethylenediamine, 1,12-dodecanediamine, 1,18-octadecanediamine, 3-methylheptamethylenediamine, 4,4-dimethylheptamethylenediamine, 4-methylnonamethylenediamine, 5-methylnonamethylenediamine, 2,5-dimethylhexamethylenediamine, 2,5-dimethylheptamethylenediamine, 2, 2-dimethylpropylenediamine, N-methyl-bis (3-aminopropyl) amine, 3-methoxyhexamethylenediamine, 1,2-bis(3-aminopropoxy) ethane, bis(3-aminopropyl) sulfide, 1,4-cyclohexanediamine, bis-(4-aminocyclohexyl) methane, m-phenylenediamine, p-phenylenediamine, 2,4-diaminotoluene, 2,6-diaminotoluene, m-xylylenediamine, p-xylylenediamine, 2-methyl-4,6-diethyl-1,3-phenylene-diamine, 5-methyl-4,6-diethyl-1,3-phenylene-diamine, benzidine, 3,3'-dimethylbenzidine, 3,3'-dimethoxybenzidine, 1,5-diaminonaphthalene, bis(4-aminophenyl) methane, bis(2-chloro-4-amino-3,5-diethylphenyl) methane, bis(4-aminophenyl) propane, 2,4-bis(p-amino-t-butyl) toluene, bis(p-amino-t-butylphenyl) ether, bis(p-methyl-o-aminophenyl) benzene, bis(p-methyl-o-aminopentyl) benzene, 1, 3-diamino-4-isopropylbenzene, bis(4-aminophenyl) sulfide, bis-(4-aminophenyl) sulfone, and bis(4-aminophenyl) ether. Combinations of these compounds can also be used. In some embodiments, the organic diamine is m-phenylenediamine, p-phenylenediamine, sulfonyl dianiline, or a combination comprising at least one of the foregoing diamines.

Included among the many methods of making polyetherimides are those disclosed in U.S. Patents 3,847,867, 3,852,242, 3,803,085, 3905,942, 3,983,093, 4,443,591, and 7,041,773. These patents are mentioned for the purpose of teaching, by way of illustration, general and specific methods for preparing polyimides. Some polyetherimide (PEI) materials are described in ASTM D5205-96 Standard Classification System for Polyetherimide Materials.

Polyetherimides can have a melt index of 0.1 to 10 grams per minute (g/min), as measured by American Society for Testing Materials (ASTM) D1238 at 340 to 370°C, using a 6.7 kilogram (kg) weight. In some embodiments, the polyetherimide polymer has a weight average molecular weight (Mw) of 1,000 to 150,000 grams/mole (Dalton), as measured by gel permeation chromatography, using polystyrene standards. In some embodiments, the polyetherimide has Mw of 10,000 to 80,000 Daltons. Such polyetherimide polymers typically have an intrinsic viscosity greater than 0.2 deciliters per gram (dl/g), or, more specifically, 0.35 to 0.7 dl/g as measured in m-cresol at 25°C.

In an embodiment, the polyetherimide comprises less than 50 ppm amine end groups. In other instances the polymer will also have less than 1 ppm of free, unpolymerized bisphenol A (BPA).

The polyetherimides can have low levels of residual volatile species, such as residual solvent and/or water. In some embodiments, the polyetherimides have a residual volatile species concentration of less than 1,000 parts by weight per million parts by weight (ppm), or, more specifically, less than 500 ppm, or, more specifically, less than 300 ppm, or, even more specifically, less than 100 ppm. In some embodiments, the composition has a residual volatile species concentration of less than 1,000 parts by weight per million parts by weight (ppm), or, more specifically, less than 500 ppm, or, more specifically, less than 300 ppm, or, even more specifically, less than 100 ppm.

Examples of residual volatile species are halogenated aromatic compounds such as chlorobenzene, dichlorobenzene, trichlorobenzene, aprotic polar solvents such as dimethyl formamide (DMF), N-methyl pyrrolidinone (NMP), dimethyl sulfoxide (DMSO), diaryl sulfones, sulfolane, pyridine, phenol, veratrole, anisole, cresols, xylenols, dichloro ethanes, tetra chloro ethanes, pyridine and mixtures thereof.

Low levels of residual volatile species in the final polymer product can be achieved by known methods, for example, by devolatilization or distillation. In some embodiments the bulk of any solvent can be removed and any residual volatile species can be removed from the polymer product by devolatilization or distillation, optionally at reduced pressure. In other embodiments the polymerization reaction is taken to some desired level of completion in solvent and then the polymerization is essentially completed and most remaining water is removed during a devolatilization step following the initial reaction in solution. Apparatuses to devolatilize the polymer mixture and reduce solvent and other volatile species to the low levels needed for good melt processability are generally capable of high temperature heating under vacuum with the ability to rapidly generate high surface area to facilitate removal of the volatile species. The mixing portions of such apparatuses are generally capable of supplying sufficient power to pump, agitate, and stir the high temperature, polyetherimide melt which can be very viscous. Suitable devolatilization apparatuses include, but are not limited to, wiped films evaporators, for example those made by the LUWA Company and devolatilizing extruders, especially twin screw extruders with multiple venting sections, for example those made by the Werner Pfleiderer Company or Welding Engineers.

In some embodiments, the polyetherimide has a glass transition temperature of 200 to 280°C.

It is often useful to melt filter the polyetherimide using known melt filtering techniques to remove foreign material, carbonized particles, cross-linked resin, or similar impurities. Melt filtering can occur during initial resin isolation or in a subsequent step. The polyetherimide can be melt filtered in the extrusion operation. Melt filtering can be performed using a filter with pore size sufficient to remove particles with a dimension of greater than or equal to 100 micrometers or with a pore size sufficient to remove particles with a dimension of greater than or equal to 40 micrometers.

In one embodiment, the polyetherimides include a polyetherimide thermoplastic resin composition, comprising: (a) a polyetherimide resin, and (b) a phosphorus-containing stabilizer, in an amount that is effective to increase the melt stability of the polyetherimide resin, wherein the phosphorus-containing stabilizer exhibits a low volatility such that, as measured by thermogravimetric analysis of an initial amount of a sample of the phosphorus-containing stabilizer, greater than or equal to 10 percent by weight of the initial amount of the sample remains unevaporated upon heating of the sample from room temperature to 300°C at a heating rate of 20°C per minute under an inert atmosphere. In one embodiment, the phosphorous-containing stabilizer has a formula P-Rₐ, where R' is independently H, alkyl, alkoxy, aryl, aryloxy, or oxy substituent and a is 3 or 4. Examples of such suitable stabilized polyetherimides can be found in U.S. Pat. No. 6,001,957, incorporated herein in its entirety.

The polyetherimide composition can optionally comprise additives such as UV absorbers, stabilizers such as light stabilizers and others, lubricants, plasticizers, pigments, dyes, colorants, anti-static agents, metal deactivators, and combinations comprising at least one of the foregoing additives. In some embodiments, the additive can include a combination of a mold release agent and a stabilizer comprising phosphite stabilizers, phosphonite stabilizers, hindered phenol stabilizers, or a combination comprising at least one of the foregoing. In an embodiment, a phosphorus-containing stabilizer is used.

Antioxidants can be compounds such as phosphites, phosphonites, hindered phenols, or combination comprising at least one of the foregoing antioxidants. Phosphorus-containing stabilizers including triaryl phosphites and aryl phosphonates are of note as useful additives. Difunctional phosphorus containing compounds can also be employed. In some embodiments, to prevent loss of the stabilizer during melt mixing or subsequent melt forming processes such as injection molding, the phosphorus containing stabilizers with a molecular weight greater than or equal to 300 Dalton, but less than or equal to 5,000 Dalton, are useful. The additive can comprise hindered phenols with molecular weight over 500 Dalton. Phosphorus-containing stabilizers can be present in the composition at 0.01 to 3.0% or to 1.0% by weight of the total composition.

The fibrous substrates further comprise fibers composed of materials other than the polyetherimides. The other fibers can be high strength, heat resistant organic fibers such as aromatic polyamides (including homopolymers and copolymers) and aromatic polyester fibers (including homopolymers and copolymers). Such fibers can have a strength of about 10 g/D to about 50 g/D, specifically 15 g/D to 50 g/D, and a pyrolysis temperature of greater than 300°C, specifically greater than about 350°C. (1 g/D = 8.830 centiNewton/tex) As used herein, an "aromatic" polymer contains at least 85 mole % of the polymer linkages (e.g., -CO-NH-) attached directly to two aromatic rings.

Wholly aromatic polyester fibers include liquid crystal polyesters. Illustrative examples of such wholly aromatic polyester fibers include self-condensed polymers of p-hydroxybenzoic acid, polyesters comprising repeat units derived from terephthalic acid and hydroquinone, polyester fibers comprising repeat units derived from p-hydroxybenzoic acid and 6-hydroxy-2-naphthoic acid, or combinations thereof. A specific wholly aromatic liquid crystal polyester fiber is produced by the polycondensation of 4-hydroxybenzoic acid and 6-hydroxynaphthalene-2-carboxylic acid (commercially available from Kuraray Co., Ltd. under the trade name designation VECTRAN). Such wholly aromatic polyester fibers may be produced by any methods known to one skilled in the art.

Aromatic polyamide fibers are also known as aramid fibers, which can be broadly categorized as para-aramid fibers or meta-aramid fibers. Illustrative examples of para-aramid fibers include poly(p-phenylene terephthalamide) fibers (produced, e.g., by E. I. Du Pont de Nemours and Company and Du Pont-Toray Co., Ltd. under the trademark KEVLAR®), p-phenylene terephthalamide/p-phenylene 3,4'-diphenylene ether terephthalamide copolymer fibers (produced by Teijin Ltd. under the trade name TECHNORA), (produced by Teijin Ltd. under the trade name designation TWARON), or a combination comprising at least one of the foregoing aromatic polyamides. Illustrative examples of meta-aramid fibers include poly(m-phenylene terephthalamide) fibers (produced, e.g., by E. I. Du Pont de Nemours and Company under the trademark NOMEX®). Such aramid fibers can be produced by methods known to one skilled in the art. In a specific embodiment, the aramid fibers are para-type homopolymers, for example poly(p-phenylene terephthalamide) fibers.

Aramid fibrids are an ingredient in the fibrous substrate. Fibrids are typically made by streaming a polymer solution into a coagulating bath of liquid that is immiscible with the solvent of the solution. The stream of polymer solution is subjected to strenuous shearing forces and turbulence as the polymer is coagulated. The fibrid material of this invention can be meta or para-aramid or blends thereof. More specifically, the fibrid is a para-aramid. Such aramid fibrids, before being dried, can be used wet and can be deposited as a binder physically entwined about the floc component of a paper.

The fibrous substrate may also comprise polycarbonate fibers. Polycarbonates are polymers having repeating structural carbonate units (1) 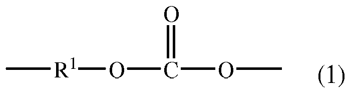 in which at least 60 percent of the total number of R¹ groups contain aromatic moieties and the balance thereof are aliphatic, alicyclic, or aromatic. In an embodiment, each R¹ is a C₆₋₃₀ aromatic group. R¹ can be derived from an aromatic dihydroxy compound of the formula HO-R¹-OH, in particular (2)

HO-A¹-Y¹-A²-OH (2)

wherein each of A¹ and A² is a monocyclic divalent aromatic group and Y¹ is a single bond or a bridging group having at least one atoms that separate A¹ from A². In an exemplary embodiment, one atom separates A¹ from A². Also included are compounds (3) 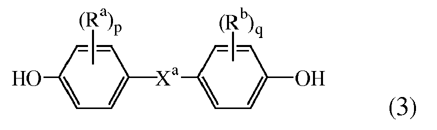 wherein R^{a} and R^{b} are each independently a halogen atom or a monovalent hydrocarbon group and may be the same or different; p and q are each independently integers of 0 to 4; and X^{a} is a bridging group connecting the two hydroxy-substituted aromatic groups, where the bridging group and the hydroxy substituent of each C₆ arylene group are disposed ortho, meta, or para (specifically para) to each other on the C₆ arylene group. In an embodiment, the bridging group X^{a} is a single bond, -O-, -S-, -S(O)-, -S(O)₂-, -C(O)-, or a C₁₋₁₈ organic group. The C₁₋₁₈ organic bridging group can be cyclic or acyclic, aromatic or non-aromatic, and can further comprise heteroatoms such as a halogen, oxygen, nitrogen, sulfur, silicon, or phosphorous. The C₁₋₁₈ organic group can be disposed such that the C₆ arylene groups connected thereto are each connected to a common alkylidene carbon or to different carbons of the C₁₋₁₈ organic bridging group. In particular, X^{a} is a C₁₋₁₈ alkylene group, a C₃₋₁₈ cycloalkylene group, or a fused C₆₋₁₈ cycloalkylene group, or a group of the formula -B¹-W-B²- wherein B¹ and B² are the same or different C₁₋₆ alkylene group and W is a C₃₋₁₂ cycloalkylidene group or a C₆₋₁₆ arylene group.

Exemplary C₁₋₁₈ organic bridging groups include methylene, cyclohexylmethylene, ethylidene, neopentylidene, and isopropylidene, as well as 2-[2.2.1]-bicycloheptylidene and cycloalkylidenes such as cyclohexylidene, cyclopentylidene, cyclododecylidene, and adamantylidene. A specific example of bisphenol (3) wherein X^{a} is a substituted cycloalkylidene is the cyclohexylidene-bridged, alkyl-substituted bisphenol (4) 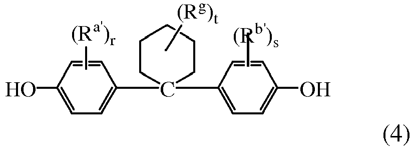 wherein R^{a'} and R^{b'} are each independently C₁₋₁₂ alkyl, R^{g} is C₁₋₁₂ alkyl or halogen, r and s are each independently 1 to 4, and t is 0 to 10. In a specific embodiment, R^{a'} and R^{b'} are disposed meta to the cyclohexylidene bridging group. The substituents R^{a'}, R^{b'}, and R^{g} can, when comprising an appropriate number of carbon atoms, be a straight chain, cyclic, bicyclic, branched, saturated, or unsaturated. In an embodiment, R^{a'} and R^{b'} are each independently C₁₋₄ alkyl, R^{g} is C₁₋₄ alkyl, r and s are each 1, and t is 0 to 5. In another specific embodiment, R^{a'} , R^{b'} and R^{g} are each methyl, r and s are each 1, and t is 0 or 3. In another exemplary embodiment, the cyclohexylidene-bridged bisphenol is the reaction product of two moles of a cresol with one mole of a hydrogenated isophorone (e.g., 1,1,3-trimethyl-3-cyclohexane-5-one).

X^{a} in bisphenol (3) can also be a substituted C₃₋₁₈ cycloalkylidene (5) 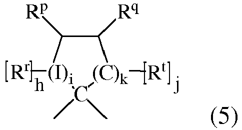 wherein R^{r}, R^{p}, R^{q}, and R^{t} are independently hydrogen, halogen, oxygen, or C₁₋₁₂ organic groups; I is a direct bond, a carbon, or a divalent oxygen, sulfur, or -N(Z)- where Z is hydrogen, halogen, hydroxy, C₁₋₁₂ alkyl, C₁₋₁₂ alkoxy, or C₁₋₁₂ acyl; h is 0 to 2, j is 1 or 2, i is an integer of 0 or 1, and k is an integer of 0 to 3, with the proviso that at least two of R^{r}, R^{p}, R^{q}, and R^{t} taken together are a fused cycloaliphatic, aromatic, or heteroaromatic ring. It will be understood that where the fused ring is aromatic, the ring as shown in formula (5) will have an unsaturated carbon-carbon linkage where the ring is fused. When k is one and i is 0, the ring as shown in formula (5) contains 4 carbon atoms, when k is 2, the ring as shown in formula (5) contains 5 carbon atoms, and when k is 3, the ring contains 6 carbon atoms. In an embodiment, two adjacent groups (e.g., R^{q} and R^{t} taken together) form an aromatic group, and in another embodiment, R^{q} and R^{t} taken together form one aromatic group and R^{r} and R^{p} taken together form a second aromatic group. When R^{q} and R^{t} taken together form an aromatic group, R^{p} can be a double-bonded oxygen atom, i.e., a ketone.

In another specific embodiment of the bisphenol compound (3), the C₁₋₁₈ organic bridging group includes groups -C(R^{c})(R^{d})- or -C(=R^{e})-, wherein R^{c} and R^{d} are each independently a hydrogen atom or a monovalent linear or cyclic hydrocarbon group and R^{e} is a divalent hydrocarbon group, p and q is each 0 or 1, and R^{a} and R^{b} are each a C₁₋₃ alkyl group, specifically methyl, disposed meta to the hydroxy group on each arylene group.

Other useful aromatic dihydroxy compounds of the formula HO-R¹-OH include compounds (7) 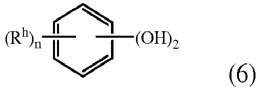 wherein each R^{h} is independently a halogen atom, a C₁₋₁₀ hydrocarbyl such as a C₁₋₁₀ alkyl group, a halogen-substituted C₁₋₁₀ alkyl group, a C₆₋₁₀ aryl group, or a halogen-substituted C₆₋₁₀ aryl group, and n is 0 to 4. The halogen is usually bromine.

Some illustrative examples of specific aromatic dihydroxy compounds include the following: 4,4'-dihydroxybiphenyl, 1,6-dihydroxynaphthalene, 2,6-dihydroxynaphthalene, bis(4-hydroxyphenyl)methane, bis(4-hydroxyphenyl)diphenylmethane, bis(4-hydroxyphenyl)-1-naphthylmethane, 1,2-bis(4-hydroxyphenyl)ethane, 1,1-bis(4-hydroxyphenyl)-1-phenylethane, 2-(4-hydroxyphenyl)-2-(3-hydroxyphenyl)propane, bis(4-hydroxyphenyl)phenylmethane, 2,2-bis(4-hydroxy-3-bromophenyl)propane, 1,1-bis (hydroxyphenyl)cyclopentane, 1,1-bis(4-hydroxyphenyl)cyclohexane, 1,1-bis(4-hydroxyphenyl)isobutene, 1,1-bis(4-hydroxyphenyl)cyclododecane, trans-2,3-bis(4-hydroxyphenyl)-2-butene, 2,2-bis(4-hydroxyphenyl)adamantane, alpha, alpha'-bis(4-hydroxyphenyl)toluene, bis(4-hydroxyphenyl)acetonitrile, 2,2-bis(3-methyl-4-hydroxyphenyl)propane, 2,2-bis(3-ethyl-4-hydroxyphenyl)propane, 2,2-bis(3-n-propyl-4-hydroxyphenyl)propane, 2,2-bis(3-isopropyl-4-hydroxyphenyl)propane, 2,2-bis(3-sec-butyl-4-hydroxyphenyl)propane, 2,2-bis(3-t-butyl-4-hydroxyphenyl)propane, 2,2-bis(3-cyclohexyl-4-hydroxyphenyl)propane, 2,2-bis(3-allyl-4-hydroxyphenyl)propane, 2,2-bis(3-methoxy-4-hydroxyphenyl)propane, 2,2-bis(4-hydroxyphenyl)hexafluoropropane, 1,1-dichloro-2,2-bis(4-hydroxyphenyl)ethylene, 1,1-dibromo-2,2-bis(4-hydroxyphenyl)ethylene, 1,1-dichloro-2,2-bis(5-phenoxy-4-hydroxyphenyl)ethylene, 4,4'-dihydroxybenzophenone, 3,3-bis(4-hydroxyphenyl)-2-butanone, 1,6-bis(4-hydroxyphenyl)-1,6-hexanedione, ethylene glycol bis(4-hydroxyphenyl)ether, bis(4-hydroxyphenyl)ether, bis(4-hydroxyphenyl)sulfide, bis(4-hydroxyphenyl)sulfoxide, bis(4-hydroxyphenyl)sulfone, 9,9-bis(4-hydroxyphenyl)fluorine, 2,7-dihydroxypyrene, 6,6'-dihydroxy-3,3,3',3'-tetramethylspiro(bis)indane ("spirobiindane bisphenol"), 3,3-bis(4-hydroxyphenyl)phthalimide, 2,6-dihydroxydibenzo-p-dioxin, 2,6-dihydroxythianthrene, 2,7-dihydroxyphenoxathin, 2,7-dihydroxy-9,10-dimethylphenazine, 3,6-dihydroxydibenzofuran, 3,6-dihydroxydibenzothiophene, and 2,7-dihydroxycarbazole, resorcinol, substituted resorcinol compounds such as 5-methyl resorcinol, 5-ethyl resorcinol, 5-propyl resorcinol, 5-butyl resorcinol, 5-t-butyl resorcinol, 5-phenyl resorcinol, 5-cumyl resorcinol, 2,4,5,6-tetrafluoro resorcinol, 2,4,5,6-tetrabromo resorcinol, or the like; catechol; hydroquinone; substituted hydroquinones such as 2-methyl hydroquinone, 2-ethyl hydroquinone, 2-propyl hydroquinone, 2-butyl hydroquinone, 2-t-butyl hydroquinone, 2-phenyl hydroquinone, 2-cumyl hydroquinone, 2,3,5,6-tetramethyl hydroquinone, 2,3,5,6-tetra-t-butyl hydroquinone, 2,3,5,6-tetrafluoro hydroquinone, 2,3,5,6-tetrabromo hydroquinone, or the like, or combinations of the foregoing dihydroxy compounds.

Specific examples of bisphenol compounds (3) include 1,1-bis(4-hydroxyphenyl) methane, 1,1-bis(4-hydroxyphenyl) ethane, 2,2-bis(4-hydroxyphenyl) propane (hereinafter "bisphenol A" or "BPA"), 2,2-bis(4-hydroxyphenyl) butane, 2,2-bis(4-hydroxyphenyl) octane, 1,1-bis(4-hydroxyphenyl) propane, 1,1-bis(4-hydroxyphenyl) n-butane, 2,2-bis(4-hydroxy-2-methylphenyl) propane, 1,1-bis(4-hydroxy-t-butylphenyl) propane, 3,3-bis(4-hydroxyphenyl) phthalimidine, 2-phenyl-3,3-bis(4-hydroxyphenyl) phthalimidine (PPPBP), and 1,1-bis(4-hydroxy-3-methylphenyl)cyclohexane (DMBPC). Combinations of the foregoing dihydroxy compounds can also be used. In one specific embodiment, the polycarbonate is a linear homopolymer derived from bisphenol A, in which each of A¹ and A² is p-phenylene and Y¹ is isopropylidene in formula (3).

"Polycarbonate" as used herein includes homopolycarbonates (wherein each R¹ in the polymer is the same), copolymers comprising different R¹ moieties in the carbonate units (referred to herein as "copolycarbonates"), copolymers comprising carbonate units and other types of polymer units, such as ester units, and combinations of homopolycarbonate and/or copolycarbonate. As used herein, a "combination" is inclusive of blends, mixtures, alloys, reaction products, and the like.

A specific polycarbonate copolymer is a poly(carbonate-ester). Such copolymers further contain, in addition to recurring carbonate units (1), repeating units (7) 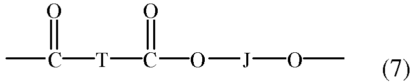 wherein J is a divalent group derived from a dihydroxy compound, and can be, for example, a C₂₋₁₀ alkylene group, a C₆₋₂₀ alicyclic group, a C₆₋₂₀ aromatic group or a polyoxyalkylene group in which the alkylene groups contain 2 to about 6 carbon atoms, specifically 2, 3, or 4 carbon atoms; and T divalent group derived from a dicarboxylic acid, and can be, for example, a C₂₋₁₀ alkylene group, a C₆₋₂₀ alicyclic group, a C₆₋₂₀ alkyl aromatic group, or a C₆-₂₀ aromatic group. Poly(carbonate-ester)s containing a combination of different T and/or J groups can be used. The poly(carbonate-ester)s can be branched or linear.

In an embodiment, J is a C₂₋₃₀ alkylene group having a straight chain, branched chain, or cyclic (including polycyclic) structure. In another embodiment, J is derived from an aromatic dihydroxy compound (3). In another embodiment, J is derived from an aromatic dihydroxy compound (4). In another embodiment, J is derived from an aromatic dihydroxy compound (6).

Exemplary aromatic dicarboxylic acids that can be used to prepare the polyester units include isophthalic or terephthalic acid, 1,2-di(p-carboxyphenyl)ethane, 4,4'-dicarboxydiphenyl ether, 4,4'-bisbenzoic acid, or a combination comprising at least one of the foregoing acids. Acids containing fused rings can also be present, such as in 1,4-, 1,5-, or 2,6-naphthalenedicarboxylic acids. Specific dicarboxylic acids include terephthalic acid, isophthalic acid, naphthalene dicarboxylic acid, cyclohexane dicarboxylic acid, or a combination of the foregoing acids. A specific dicarboxylic acid comprises a combination of isophthalic acid and terephthalic acid wherein the weight ratio of isophthalic acid to terephthalic acid is about 91:9 to about 2:98. In another specific embodiment, J is a C₂₋₆ alkylene group and T is p-phenylene, m-phenylene, naphthalene, a divalent cycloaliphatic group, or a combination comprising at least one of the foregoing.

The molar ratio of carbonate units to ester units in the copolymers can vary broadly, for example 1:99 to 99:1, specifically 10:90 to 90:10, more specifically 25:75 to 75:25, depending on the desired properties of the final composition.

A specific embodiment of a poly(carbonate-ester) (8) comprises recurring aromatic carbonate and aromatic ester units 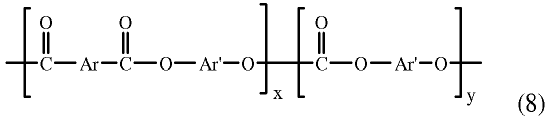 wherein Ar is divalent aromatic residue of a dicarboxylic acid or combination of dicarboxylic acids, and Ar' is a divalent aromatic residue of a bisphenol (3) or a dihydric compound (6). Ar is thus an aryl group, and is more specifically the residue of isophthalic acid (9a), terephthalic acid (9b), 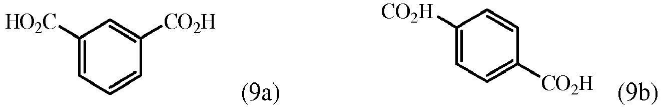 or a combination comprising at least one of the foregoing. Ar' may be polycyclic, e.g., a residue of biphenol or bisphenol A, or monocyclic, e.g., the residue of hydroquinone or resorcinol.

Further in the poly(carbonate-ester)s (8), x and y represent the respective parts by weight of the aromatic ester units and the aromatic carbonate units based on 100 parts total weight of the copolymer. Specifically, x, the aromatic ester content, is 20 to 100, specifically 30 to 95, still more specifically 50 to 95 parts by weight, and y, the carbonate content, is from more than zero to 80, from 5 to 70, still more specifically from 5 to 50 parts by weight. In general, any aromatic dicarboxylic acid used in the preparation of polyesters may be utilized in the preparation of poly(carbonate-ester)s (8) but terephthalic acid alone can be used, or mixtures thereof with isophthalic acid wherein the weight ratio of terephthalic acid to isophthalic acid is in the range of from 5:95 to 95:5. In this embodiment, the poly(carbonate-ester)s (8) can be derived from the reaction of bisphenol-A and phosgene with iso- and terephthaloyl chloride, and can have an intrinsic viscosity of 0.5 to 0.65 deciliters per gram (measured in methylene chloride at a temperature of 25°C). Copolymers of formula (8) comprising 35 to 45 wt.% of carbonate units and 55 to 65 wt.% of ester units, wherein the ester units have a molar ratio of isophthalate to terephthalate of 45:55 to 55:45 are often referred to as poly(carbonate-ester)s (PCE) and copolymers comprising 15 to 25 wt.% of carbonate units and 75 to 85 wt.% of ester units having a molar ratio of isophthalate to terephthalate from 98:2 to 88:12 are often referred to as poly(phthalate-carbonate)s (PPC).

In another specific embodiment, the poly(carbonate-ester)s comprise carbonate units (1) derived from a bisphenol compound (3), and ester units derived from an aromatic dicarboxylic acid and dihydroxy compound (6). Specifically, the ester units are arylate ester units (9) 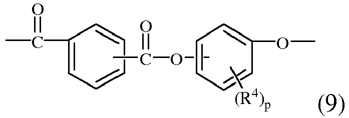 wherein each R⁴ is independently a halogen or a C₁₋₄ alkyl, and p is 0 to 3. The arylate ester units can be derived from the reaction of a mixture of terephthalic acid and isophthalic acid or chemical equivalents thereof with compounds such as 5-methyl resorcinol, 5-ethyl resorcinol, 5-propyl resorcinol, 5-butyl resorcinol, 5-t-butyl resorcinol, 2,4,5-trifluoro resorcinol, 2,4,6-trifluoro resorcinol, 4,5,6-trifluoro resorcinol, 2,4,5-tribromo resorcinol, 2,4,6-tribromo resorcinol, 4,5,6-tribromo resorcinol, catechol, hydroquinone, 2-methyl hydroquinone, 2-ethyl hydroquinone, 2-propyl hydroquinone, 2-butyl hydroquinone, 2-t-butyl hydroquinone, 2,3,5-trimethyl hydroquinone, 2,3,5-tri-t-butyl hydroquinone, 2,3,5-trifluoro hydroquinone, 2,3,5-tribromo hydroquinone, or a combination of the foregoing compounds. The ester units can be poly(isophthalate-terephthalate-resorcinol ester) units, also known as "ITR" esters.

The poly(carbonate-ester)s comprising ester units (9) can comprise, based on the total weight of the copolymer, from 1 to less than 100 wt.%, 10 to less than 100 wt.%, 20 to less than 100 wt.%, or 40 to less than 100 wt.% of carbonate units (1) derived from a bisphenol compound (3), and from greater than 0 to 99 wt.%, greater than 0 to 90 wt.%, greater than 0 to 80 wt.%, or greater than 0 to 60 wt.% of ester units derived from an aromatic dicarboxylic acid and dihydroxy compound (6). A specific poly(carbonate-ester) comprising arylate ester units (9) is a poly(bisphenol-A carbonate)-co-poly(isophthalate-terephthalate-resorcinol ester).

In another specific embodiment, the poly(carbonate-ester)s contain carbonate units (1) derived from a combination of a bisphenol (3) and a dihydroxy compound (6), and arylate ester units (9). The molar ratio of carbonate units derived from dihydroxy compound (3) to carbonate units derived from dihydroxy compound (6) can be 1:99 to 99:1. A specific poly(carbonate-ester) of this type is a poly(bisphenol-A carbonate)-co-(resorcinol carbonate)-co(isophthalate-terephthalate-resorcinol ester).

Polycarbonates can be manufactured by processes such as interfacial polymerization and melt polymerization. Although the reaction conditions for interfacial polymerization can vary, an exemplary process generally involves dissolving or dispersing a dihydric phenol reactant in aqueous caustic soda or potash, adding the resulting mixture to a water-immiscible solvent medium, and contacting the reactants with a carbonate precursor in the presence of a catalyst such as triethylamine and/or a phase transfer catalyst, under controlled pH conditions, e.g., about 8 to about 12. The most commonly used water immiscible solvents include methylene chloride, 1,2-dichloroethane, chlorobenzene, toluene, and the like.

Exemplary carbonate precursors include a carbonyl halide such as carbonyl bromide or carbonyl chloride, or a haloformate such as a bishaloformates of a dihydric phenol (e.g., the bischloroformates of bisphenol A, hydroquinone, or the like) or a glycol (e.g., the bishaloformate of ethylene glycol, neopentyl glycol, polyethylene glycol, or the like). Combinations of at least one of the foregoing types of carbonate precursors can also be used. In an exemplary embodiment, an interfacial polymerization reaction to form carbonate linkages uses phosgene as a carbonate precursor, and is referred to as a phosgenation reaction.

Among the phase transfer catalysts that can be used are catalysts of the formula (R³)₄Q⁺X, wherein each R³ is the same or different, and is a C₁₋₁₀ alkyl group; Q is a nitrogen or phosphorus atom; and X is a halogen atom or a C₁₋₈ alkoxy group or C₆₋₁₈ aryloxy group. Exemplary phase transfer catalysts include, for example, [CH₃(CH₂)₃]₄,NX, [CH₃(CH₂)₃]₄PX, [CH₃(CH₂)₅]₄NX, [CH₃(CH₂)₆]₄NX, [CH₃(CH₂)₄]₄NX, CH₃[CH₃(CH₂)₃]₃NX, and CH₃[CH₃(CH₂)₂]₃NX, wherein X is Cl⁻, Br⁻, a C₁₋₈ alkoxy group or a C₆₋₁₈ aryloxy group. An effective amount of a phase transfer catalyst can be about 0.1 to about 10 wt.% based on the weight of bisphenol in the phosgenation mixture. In another embodiment, an effective amount of phase transfer catalyst can be about 0.5 to about 2 wt.% based on the weight of bisphenol in the phosgenation mixture.

All types of polycarbonate end groups are contemplated as being useful in the polycarbonate composition, provided that such end groups do not significantly adversely affect desired properties of the compositions.

Branched polycarbonate blocks can be prepared by adding a branching agent during polymerization. These branching agents include polyfunctional organic compounds containing at least three functional groups comprising hydroxyl, carboxyl, carboxylic anhydride), haloformyl, or mixtures of the foregoing functional groups. Specific examples include trimellitic acid, trimellitic anhydride), trimellitic trichloride, tris-p-hydroxy phenyl ethane, isatin-bis-phenol, tris-phenol TC (1,3,5-tris((p-hydroxyphenyl)isopropyl)benzene), tris-phenol PA (4(4(1,1-bis(p-hydroxyphenyl)-ethyl) alpha, alpha-dimethyl benzyl)phenol), 4-chloroformyl phthalic anhydride, trimesic acid, and benzophenone tetracarboxylic acid. The branching agents can be added at a level of about 0.05 to about 2.0 wt.%. Mixtures comprising linear polycarbonates and branched polycarbonates can be used.

A chain stopper (also referred to as a capping agent) can be included during polymerization. The chain stopper limits molecular weight growth rate, and so controls molecular weight in the polycarbonate. Exemplary chain stoppers include certain mono-phenolic compounds, mono-carboxylic acid chlorides, and/or mono-chloroformates. Mono-phenolic chain stoppers are exemplified by monocyclic phenols such as phenol and C₁-C₂₂ alkyl-substituted phenols such as p-cumyl-phenol, resorcinol monobenzoate, and p-and tertiary-butyl phenol; and monoethers of diphenols, such as p-methoxyphenol. Alkyl-substituted phenols with branched chain alkyl substituents having 8 to 9 carbon atoms can be specifically mentioned. Certain mono-phenolic UV absorbers can also be used as a capping agent, for example 4-substituted-2-hydroxybenzophenones and their derivatives, aryl salicylates, monoesters of diphenols such as resorcinol monobenzoate, 2-(2-hydroxyaryl)-benzotriazoles and their derivatives, 2-(2-hydroxyaryl)-1,3,5-triazines and their derivatives, and the like.

Mono-carboxylic acid chlorides can also be used as chain stoppers. These include monocyclic, mono-carboxylic acid chlorides such as benzoyl chloride, C₁-C₂₂ alkyl-substituted benzoyl chloride, toluoyl chloride, halogen-substituted benzoyl chloride, bromobenzoyl chloride, cinnamoyl chloride, 4-nadimidobenzoyl chloride, or a combination comprising at least one of the foregoing monocyclic chlorides; polycyclic, mono-carboxylic acid chlorides such as trimellitic anhydride chloride, and naphthoyl chloride; or a combination comprising at least one of the foregoing monocyclic and polycyclic mono-carboxylic acid chlorides. Chlorides of aliphatic monocarboxylic acids with less than or equal to about 22 carbon atoms are useful. Functionalized chlorides of aliphatic monocarboxylic acids, such as acryloyl chloride and methacryoyl chloride, are also useful. Also useful are mono-chloroformates including monocyclic, mono-chloroformates, such as phenyl chloroformate, alkyl-substituted phenyl chloroformate, p-cumyl phenyl chloroformate, toluene chloroformate, or a combination comprising at least one of the foregoing chloroformates.

Alternatively, melt processes can be used to make the polycarbonates. Generally, in the melt polymerization process, polycarbonates can be prepared by co-reacting, in a molten state, the dihydroxy reactant(s) and a diaryl carbonate ester, such as diphenyl carbonate, in the presence of a transesterification catalyst in a Banbury^{®} mixer, twin screw extruder, or the like to form a uniform dispersion. Volatile monohydric phenol is removed from the molten reactants by distillation and the polymer is isolated as a molten residue. A specifically useful melt process for making polycarbonates uses a diaryl carbonate ester having electron-withdrawing substituents on the aryls. Examples of specifically useful diaryl carbonate esters with electron withdrawing substituents include bis(4-nitrophenyl)carbonate, bis(2-chlorophenyl)carbonate, bis(4-chlorophenyl)carbonate, bis(methyl salicyl)carbonate, bis(4-methylcarboxylphenyl) carbonate, bis(2-acetylphenyl) carboxylate, bis(4-acetylphenyl) carboxylate, or a combination comprising at least one of the foregoing esters. In addition, useful transesterification catalysts can include phase transfer catalysts of formula (R³)₄Q⁺X, wherein each R³, Q, and X are as defined above. Exemplary transesterification catalysts include tetrabutylammonium hydroxide, methyltributylammonium hydroxide, tetrabutylammonium acetate, tetrabutylphosphonium hydroxide, tetrabutylphosphonium acetate, tetrabutylphosphonium phenolate, or a combination comprising at least one of the foregoing transesterification catalysts.

The polyester-polycarbonates in particular can also be prepared by interfacial polymerization as described above with respect to polycarbonates generally. Rather than utilizing the dicarboxylic acid or diol per se, the reactive derivatives of the acid or diol, such as the corresponding acid halides, in particular the acid dichlorides and the acid dibromides can be used. Thus, for example instead of using isophthalic acid, terephthalic acid, or a combination comprising at least one of the foregoing acids, isophthaloyl dichloride, terephthaloyl dichloride, or a combination comprising at least one of the foregoing dichlorides can be used.

The polycarbonates can have an intrinsic viscosity, as determined in chloroform at 25°C, of 0.3 to 1.5 deciliters per gram (dl/gm), specifically 0.45 to 1.0 dl/gm. The polycarbonates can have a weight average molecular weight of 10,000 to 200,000 Daltons, specifically 20,000 to 100,000 Daltons, as measured by gel permeation chromatography (GPC), using a cross-linked styrene-divinylbenzene column and calibrated to polycarbonate references. GPC samples are prepared at a concentration of 1 mg per ml, and are eluted at a flow rate of 1.5 ml per minute. Combinations of polycarbonates of different flow properties can be used to achieve the overall desired flow property. In an embodiment, polycarbonates are based on bisphenol A, in which each of A³ and A⁴ is p-phenylene and Y² is isopropylidene. The weight average molecular weight of the polycarbonate can be 5,000 to 100,000 Daltons, or, more specifically 10,000 to 65,000 Daltons, or, even more specifically, 15,000 to 35,000 Daltons as determined by GPC as described above.

The polyester-polycarbonates in particular are generally of high molecular weight and have an intrinsic viscosity, as determined in chloroform at 25°C of 0.3 to 1.5 dl/gm, and more specifically from 0.45 to 1.0 dl/gm. These polyester-polycarbonates may be branched or unbranched and generally will have a weight average molecular weight of from 10,000 to 200,000, more specifically from 20,000 to 100,000 as measured by gel permeation chromatography.

Polycarbonates containing poly(carbonate-siloxane) blocks can be used. The polysiloxane blocks are polydiorganosiloxane, comprising repeating diorganosiloxane units as in formula (10) 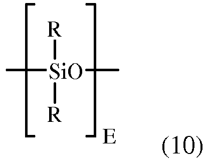 wherein each R is independently the same or different C₁₋₁₃ monovalent organic group. For example, R can be a C₁-C₁₃ alkyl, C₁-C₁₃ alkoxy, C₂-C₁₃ alkenyl group, C₂-C₁₃ alkenyloxy, C₃-C₆ cycloalkyl, C₃-C₆ cycloalkoxy, C₆-C₁₄ aryl, C₆-C₁₀ aryloxy, C₇-C₁₃ arylalkyl, C₇-C₁₃ aralkoxy, C₇-C₁₃ alkylaryl, or C₇-C₁₃ alkylaryloxy. The foregoing groups can be fully or partially halogenated with fluorine, chlorine, bromine, or iodine, or a combination comprising at least one of the foregoing halogens. In an embodiment, where a transparent polysiloxane-polycarbonate is desired, R is unsubstituted by halogen. Combinations of the foregoing R groups can be used in the same copolymer.

The value of E in formula (10) can vary widely depending on the type and relative amount of each component in the thermoplastic composition, the desired properties of the composition, and like considerations. Generally, E has an average value of 2 to about 1,000, specifically about 2 to about 500, more specifically about 5 to about 100. In one embodiment, E has an average value of about 10 to about 75, and in still another embodiment, E has an average value of about 40 to about 60. Where E is of a lower value, e.g., less than about 40, it can be desirable to use a relatively larger amount of the polycarbonate-polysiloxane copolymer. Conversely, where E is of a higher value, e.g., greater than about 40, a relatively lower amount of the polycarbonate-polysiloxane copolymer can be used.

A combination of a first and a second (or more) poly(carbonate-siloxane) copolymers can be used, wherein the average value of E of the first copolymer is less than the average value of E of the second copolymer.

In an embodiment, the polydiorganosiloxane blocks are of formula (11) 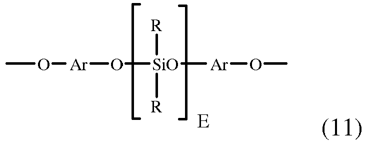 wherein E is as defined above; each R can be the same or different, and is as defined above; and Ar can be the same or different, and is a substituted or unsubstituted C₆-C₃₀ arylene group, wherein the bonds are directly connected to an aromatic moiety. Ar groups in formula (11) can be derived from a C₆-C₃₀ dihydroxyarylene compound, for example a dihydroxyarylene compound of formula (3) or (6) above. Exemplary dihydroxyarylene compounds are 1,1-bis(4-hydroxyphenyl) methane, 1,1-bis(4-hydroxyphenyl) ethane, 2,2-bis(4-hydroxyphenyl) propane, 2,2-bis(4-hydroxyphenyl) butane, 2,2-bis(4-hydroxyphenyl) octane, 1,1-bis(4-hydroxyphenyl) propane, 1,1-bis(4-hydroxyphenyl) n-butane, 2,2-bis(4-hydroxy-1-methylphenyl) propane, 1,1-bis(4-hydroxyphenyl) cyclohexane, bis(4-hydroxyphenyl sulfide), and 1,1-bis(4-hydroxy-t-butylphenyl) propane. Combinations comprising at least one of the foregoing dihydroxy compounds can also be used.

In another embodiment, polydiorganosiloxane blocks are of formula (12) 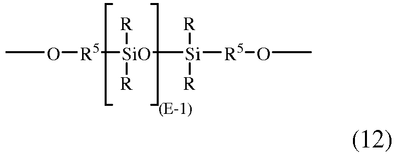 wherein R and E are as described above, and each R⁵ is independently a divalent C₁-C₃₀ hydrocarbon group, and wherein the polymerized polysiloxane unit is the reaction residue of its corresponding dihydroxy compound.

In a specific embodiment, the polydiorganosiloxane blocks are of formula (13) 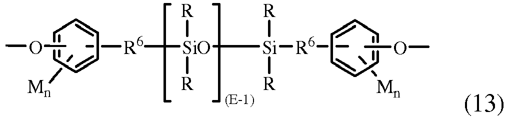 wherein R and E are as defined above. R⁶ in formula (13) is a divalent C₂-C₈ aliphatic group. Each M in formula (14) can be the same or different, and can be a halogen, cyano, nitro, C₁-C₈ alkylthio, C₁-C₈ alkyl, C₁-C₈ alkoxy, C₂-C₈ alkenyl, C₂-C₈ alkenyloxy group, C₃-C₈ cycloalkyl, C₃-C₈ cycloalkoxy, C₆-C₁₀ aryl, C₆-C₁₀ aryloxy, C₇-C₁₂ aralkyl, C₇-C₁₂ aralkoxy, C₇-C₁₂ alkylaryl, or C₇-C₁₂ alkylaryloxy, wherein each n is independently 0, 1, 2, 3, or 4.

In an embodiment, M is bromo or chloro, an alkyl group such as methyl, ethyl, or propyl, an alkoxy group such as methoxy, ethoxy, or propoxy, or an aryl group such as phenyl, chlorophenyl, or tolyl; R² is a dimethylene, trimethylene or tetramethylene group; and R is a C₁₋₈ alkyl, haloalkyl such as trifluoropropyl, cyanoalkyl, or aryl such as phenyl, chlorophenyl or tolyl. In another embodiment, R is methyl, or a combination of methyl and trifluoropropyl, or a combination of methyl and phenyl. In still another embodiment, M is methoxy, n is one, R² is a divalent C₁-C₃ aliphatic group, and R is methyl.

Blocks of formula (13) can be derived from the corresponding dihydroxy polydiorganosiloxane (14) 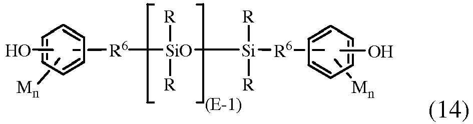 wherein R, E, M, R⁶, and n are as described above. Such dihydroxy polysiloxanes can be made by effecting a platinum-catalyzed addition between a siloxane hydride of formula (15) 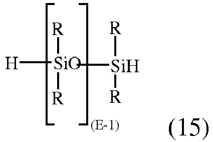 wherein R and E are as previously defined, and an aliphatically unsaturated monohydric phenol. Exemplary aliphatically unsaturated monohydric phenols include eugenol, 2-alkylphenol, 4-allyl-2-methylphenol, 4-allyl-2-phenylphenol, 4-allyl-2-bromophenol, 4-allyl-2-t-butoxyphenol, 4-phenyl-2-phenylphenol, 2-methyl-4-propylphenol, 2-allyl-4,6-dimethylphenol, 2-allyl-4-bromo-6-methylphenol, 2-allyl-6-methoxy-4-methylphenol and 2-allyl-4,6-dimethylphenol. Combinations comprising at least one of the foregoing can also be used.

The poly(carbonate-siloxane)s can comprise 50 to 99 wt.% of carbonate units and 1 to 50 wt.% siloxane units. Within this range, the poly(carbonate-siloxane)s can comprise 70 to 98 wt.%, more specifically 75 to 97 wt.% of carbonate units and 2 to 30 wt.%, more specifically 3 to 25 wt.% siloxane units.

The poly(carbonate-siloxane)s can have a weight average molecular weight of 2,000 to 100,000 Daltons, specifically 5,000 to 50,000 Daltons as measured by gel permeation chromatography using a cross-linked styrene-divinyl benzene column, at a sample concentration of 1 milligram per milliliter, and as calibrated with polycarbonate standards.

The poly(carbonate-siloxane) can have a melt volume flow rate, measured at 300°C/1.2 kg, of 1 to 50 cubic centimeters per 10 minutes (cc/10 min), specifically 2 to 30 cc/10 min. Mixtures of polyorganosiloxane-polycarbonates of different flow properties can be used to achieve the overall desired flow property.

The foregoing polycarbonates can be used alone or in combination, for example a combination of a homopolycarbonate and at least one poly(carbonate-ester)s, or a combination of two or more poly(carbonate-ester)s. Blends of different poly(carbonate-ester)s may be used in these compositions.

In some embodiments, the resins which comprise the fibrous substrate could also be combined during a fiber extrusion process known as bi-component fiber extrusion. In such embodiments, a first polymer can be melt spun along with a second polymer to form a core/sheath fiber according to known methods. Methods for making bi-component and multicomponent fibers are well known and need not be described here in detail. For example, U.S. Patent 5,227,109, which is hereby incorporated by reference, describes forming bi-component fibers in a sheath-core relationship in a spinning pack that incorporates a plurality of adjacent plates that define selected flow paths therein for a sheath component and a core component to direct the respective components into the sheath-core relationship. In addition, more complex multicomponent fiber morphologies may be considered within the term core sheath as used herein, such as disclosed in U.S. Patent 5,458,972, which is hereby incorporated by reference, and describes a method of producing a multicomponent trilobal fiber using a trilobal capillary defining three legs, three apexes and an axial center, by directing a first molten polymer composition to the axial center and presenting a second molten polymer composition to at least one of the apexes. The fiber produced has a trilobal core defining an outer core surface and a sheath abutting at least about one-third of the outer core surface.

In various embodiments, the first polymer can be the core fiber while the second polymer is the sheath fiber, or the second polymer can be the core fiber while the first polymer is the sheath fiber. The first and second polymer can be any of the polymers described above in the context of the useful fibers.

In an embodiment, polyetherimide would be the core and polycarbonate would be the outer layer. The embodiment would make bonding the fibers in the mat more uniform. In another embodiment, any high temperature, high strength polymer would be the core and the polyetherimide the outer layer. Examples of such core polymers include materials subject to stress-induced crystallization, semi-crystalline, or crystalline polymers, such as polyethylene terephthalates and variants of semi-crystalline polyethylenes and propylenes, such as Spectra and Dyneema, liquid crystal polymers, aramids (para- and meta-), poly(p-phenylene-2,6-benzobisoxazole) Zylon, polyacrylonitrile fibers, polyamides, and in some embodiments silicon nitride, and carbon fibers. This embodiment would improve the uniformity of dispersion of the materials over a given area in construction of the paper. This embodiment could also allow for the production of finer fiber, which is critical for uniform dispersion in very thin products such as this.

The electrical insulation paper may be made using known paper making techniques, such as on cylinder or fourdrinier paper making machines. In general, fibers are chopped and refined to obtain the proper fiber size. The synthetic fibers and binder are added to a suspension solvent, such as water, to form a mixture of fibers and water.

The mixture then is screened to drain the water from the mixture to form a sheet of paper. The screen tends to orient the fibers in the direction in which the sheet is moving, which is referred to as the machine direction. Consequently, the resulting insulation paper has a greater tensile strength in the machine direction than in the perpendicular direction, which is referred to as the cross direction. The sheet of paper is fed from the screen onto rollers and through other processing equipment that removes the water in the paper.

The substrate can further comprise a layer of polymer film bound to surfaces of the fibrous substrate. Such films can include any polymer which, when used as described, produces final properties in the ranges described in the claims. In an exemplary embodiment, the polymer film is polyetherimide film. The polymer film can be greater than 0 to 50 µm in thickness; 4 to 40 µm; 5 to 30 µm. Generally the polymer film is bound to a first and a second surface of the fibrous substrate. In addition, multiple layers of fibrous substrate and polymer film can be combined. For example, two layers of fibrous substrates can be alternated with three layers of polymer film. It is recommended that the combinations of fibrous substrates and polymer films be bilaterally symmetrical in order to avoid warpage. The stack of fibrous substrate(s) and polymer film(s) are generally bound by consolidation in a press.

The fibrous substrate can have an electrical breakdown strength of 400 Volt/mil, for example 450, 500, 550, 600, 650, 700, 750, 800, 850, 900, 950 or greater than 1000 Volt/mil (V/mil = 0.3937 kV/cm which converts the foregoing to 177, 197, 216, 236, 256, 276, 295, 315, 335, 354, 374, or greater than 394 kV/cm).

The fibrous substrate can be prepared in various aereal densities known in the art, which are generally expressed in grams per square meter (GSM). Generally the density of the fibrous substrates can be 5 to 200 GSM; 20 to 100 GSM. In an exemplary embodiment the consolidated fibrous substrate has a density of 80 GSM.

The fibrous substrate can be prepared having various porosities. Methods of measuring porosity are known to those skilled in the art, such as ISO 5636-5:2003. In this technique, the Gurley second or Gurley unit is a unit describing the number of seconds required for 100 cubic centimeters (1 deciliter) of air to pass through 1.0 square inch of a given material at a pressure differential of 4.88 inches of water (0.188 psi ), which can be expressed as square inch seconds per deciliter (s·in²/dl). In SI units, 1 s·in²/dl = 6.4516 seconds per meter column of air (s/m). In one embodiment, the electrical insulation paper has a porosity of greater than 10 to less than 120 s·in²/dl (Gurley second) (greater than 64 to less than 774 seconds per meter column of air).

In another general aspect, a method of constructing an electrical device includes providing a conductor, providing an electrical insulation paper, and surrounding at least part of the conductor with the insulation paper.

In another general aspect, an insulated conductor includes an electrical conductor that is surrounded at least partly by an electrical insulation paper. In some applications, the insulated conductor can be installed in a transformer.

The fibrous substrate has a thickness of more than 0 to less than 800 micrometers (µm). In some embodiments, the thickness is 0 to 500 µm. In other embodiments, the thickness is 25 to 200 µm.

The fibrous substrate generally has 5 or less wt.% gain due to water saturation at 100% Relative Humidity. In other embodiments, the wt.% gain is 3% or less, and in an exemplary embodiment the wt.% gain is 2% or less.

Although the foregoing embodiments have been directed to embodiments in which liquid crystal polymers are used, it is envisioned that in some embodiments, it is possible to make fibrous substrates without liquid crystal polymers. As such, in some embodiments, our invention is directed to a fibrous substrate comprising a consolidated product of a fiber composition comprising, based on the total weight of fibers in the fiber composition:
35 to 70 wt.% of polyetherimide fibers having a polydispersity index of 2.2 to 2.5, and in some embodiments 20 to 80 wt.% polyimide fibers;
at least 5 wt.% of aromatic polyamide fibrids;
each based on the total weight of the fibers in the fiber composition;
wherein the polyimide fibers and the aromatic polyamide fibrids are present in amounts sufficient to produce a fibrous substrate having:
(1) resistivity of at least 100MOhm-cm;
(2) electrical breakdown strength of at least 400, or higher 600 Volt/mil;
(3) thermal capability exceeding the standards for NEMA Class F (155°C) and NEMA Class H (180°C) insulation, and has 5 or less wt.% gain due to water saturation at 100% Relative Humidity;
(4) tear strength, measured as Elmendorf tear strength of at least 85mN; and
(5) a thickness of more than 0 to less than 500 µm.

The following Examples are illustrative, and non-limiting.

### EXAMPLES

### Materials

The following materials were used in the Examples.

**Table 1.**

| Component | Chemical Description | Source, Vendor |
|---|---|---|
| ULTEM 9011 | Polyetherimide | SABIC Innovative Polymers |
| VECTRAN | Liquid-Crystal Polymer Spun Fiber | Kuraray Co., Ltd |
| TWARON | Aramid Fiber | Teijin Aramid BV |
| NOMEX | Aramid Electrical Grade Paper | DuPont |

| | | |
|---|---|---|
| Twaron is a para-aramid polymer, specifically poly p-phenylene terephthalamide (PpPTA), commercially available from Teijin Aramid BV. | | |

### Techniques and Procedures

Paper Making Technique: A fiber slurry was formed by combining the fibers in water. The fibers were deposited on a mesh to form a layer and dewatered in a 12-inch x 12-inch hand press. Consolidation of the layers was performed as follows.

Consolidation conditions: A TMP Vacuum press was prepared to accept the sample by loading a silicone bladder and a cover sheet of aluminum foil overlaying the lower stainless steel plate. The sample of mixed fibers was removed from the hand press and placed on top of the aluminum foil. Then the press platens was closed, bringing the upper stainless steel plate in contact with the sample at an initial temperature of 100°F and a minimum system pressure of 5 tons. The temperature selector was then set for 460°F. When the temperature indicator displays 350°F, close the containment doors and activate vacuum with the control set to full and maintain pressure below 28.9 mm Hg. When platens reach 460°F, reduce temperature setting to 100°F to start cooling, and increase pressure setting to 200 tons (2,778 psi) and hold. When temperature cools to 100°F, turn off vacuum, set pressure to zero, and open to remove sample.

AC Breakdown Strength Test Procedure - ASTM D-149, using 1" on 3" diameter electrodes, tested in air or oil impregnated. Ramp of 100 V/sec, and trip limit of about 0.1mA.

### EXAMPLES 1 AND 2, COMPARATIVE EXAMPLES A, B, C, D, & E:

Fibers of the identified materials were obtained in the sizes described, combined together in the stated proportions and made into paper according to the described technique:

Examples 1 and 2: 65% Ultem fiber - 2 dpf x 6 mm; 25% Vectran fiber - 2.8 dtex x 5 mm; 10% Twaron fibrids.

Comparative Example A is Nomex® electrical grade paper.

Comparative Examples B, C, D, & E: 65% Ultem fiber - 2 dpf x 6 mm; 25% Vectran fiber - 2.8 dtex x 5 mm; 10% Lexan FST fibers - 2dpf x 6 mm.

The samples were evaluated according to the AC Breakdown Strength Procedure and the results are reported in Table 2.

**Table 2.**

| Sample | AC Breakdown Strength (V/mil) |
|---|---|
| Comparative Example A | 620 |
| Example 1 | 650 |
| Example 2 | 715 |
| Comparative Example B | 505 |
| Comparative Example C | 500 |
| Comparative Example D | 475 |
| Comparative Example E | 440 |

| | |
|---|---|
| (V/mil = 0.3937 kV/cm) | |

The electrical grade papers according to the invention, Examples 1 and 2 which contain polyaramid fibrids, achieved AC Breakdown Strength ("BDS") performance superior to the Nomex paper of Comparative Example A. Example 1 registered a BDS of 650 V/mil and Example 2 a BDS of 715 V/mil, which both exceeded the BDS for Comparative Example A, 620 V/mil. All three samples were the same thickness, 3 mil. Comparative Examples B, C, D, & E, which contain Lexan FST in place of the polyaramid fibrids, registered Breakdown Strength inferior to the Nomex of Comparative Example A.

In general, the compositions or methods may alternatively comprise, consist of, or consist essentially of, any appropriate components or steps herein disclosed. The invention may additionally, or alternatively, be formulated so as to be devoid, or substantially free, of any components, materials, ingredients, adjuvants, or species, or steps used in the prior art compositions or that are otherwise not necessary to the achievement of the function and/or objectives of the present claims.

"Optional" or "optionally" means that the subsequently described event or circumstance may or may not occur, and that the description includes instances where the event occurs and instances where it does not.

The modifier "about" used in connection with a quantity is inclusive of the stated value and has the meaning dictated by the context (e.g., includes the degree of error associated with measurement of the particular quantity).

The notation "±10%" means that the indicated measurement may be from an amount that is minus 10% to an amount that is plus 10% of the stated value.

The endpoints of all ranges directed to the same component or property are inclusive of the endpoints, are independently combinable, and include all intermediate points and ranges optional: (e.g., ranges of "up to about 25 wt.%, or, more specifically, about 5 wt.% to about 20 wt.%," is inclusive of the endpoints and all intermediate values of the ranges of "about 5 wt.% to about 25 wt.%," such as about 10 wt.% to about 23 wt.%, etc.).

The suffix "(s)" as used herein is intended to include both the singular and the plural of the term that it modifies, thereby including one or more of that term (e.g., the colorant(s) includes one or more colorants).

The terms "first," "second," and the like, "primary," "secondary," and the like, as used herein do not denote any order, quantity, or importance, but rather are used to distinguish one element from another.

The terms "front," "back," "bottom," and/or "top" are used herein, unless otherwise noted, merely for convenience of description, and are not limited to any one position or spatial orientation.

The term "combination" is inclusive of blends, mixtures, alloys, reaction products, and the like.

Unless defined otherwise, technical and scientific terms used herein have the same meaning as is commonly understood by one of skill in the art to which this invention belongs.

Compounds are described using standard nomenclature. For example, any position not substituted by any indicated group is understood to have its valency filled by a bond as indicated, or a hydrogen atom. A dash ("-") that is not between two letters or symbols is used to indicate a point of attachment for a substituent. For example, -CHO is attached through carbon of the carbonyl group.

All cited patents, patent applications, and other references are incorporated herein by reference in their entirety. However, if a term in the present application contradicts or conflicts with a term in the incorporated reference, the term from the present application takes precedence over the conflicting term from the incorporated reference.

The invention includes at least the following embodiments.
Embodiment 1: A fibrous substrate comprising a consolidated product of a fiber composition comprising, based on the total weight of fibers in the fiber composition: 35 to 70 wt.% of polyimide fibers; at least 5 wt.% of aromatic polyamide fibrids; 20 to 30 wt.% of liquid crystal polymer fibers, each based on the total weight of the fibers in the fiber composition; wherein the consolidated product has a thickness of more than 0 to less than 200 µm.
Embodiment 2: The fibrous substrate of Embodiment 1, wherein the substrate comprises less than 10 wt.% of a polycarbonate fiber.
Embodiment 3: The fibrous substrate of Embodiment 1 or 2, wherein the fiber composition is 50 to 70 wt.% of polyimide fibers; greater than 5 to 20 wt.% of aromatic polyamide fibrids; and 25 to 30 wt.% of liquid crystal polymer fibers.
Embodiment 4: The fibrous substrate of Embodiment 1 or 2, wherein the fiber composition is 60 to 70 wt.% of polyimide fibers; greater than 5 to 20 wt.% of aromatic polyamide fibers; and 5 to 20 wt.% of liquid crystal polymer fibers.
Embodiment 5: The fibrous substrate of any of the preceding Embodiments, wherein the polyimide fibers are polyetherimides having a polydispersity index of 2.2 to 2.5.
Embodiment 6: The fibrous substrate of any of the preceding Embodiments, wherein the aromatic polyamide is an aromatic para-polyamide.
Embodiment 7: The fibrous substrate of any of the preceding Embodiments, wherein the aromatic polyamide is poly(p-phenylene terephthalamide), poly(p-phenylene terephthalamide-co-3'4'-oxydiphenylene terephthalamide), or a combination comprising at least one of the foregoing aramid.
Embodiment 8: The fibrous substrate of any of the preceding Embodiments, wherein the liquid crystal polyester is poly(4-hydroxybenzoic acid-co-6-hydroxy-2-naphthoic acid).
Embodiment 9:: The fibrous substrate of Embodiment 1, wherein the substrate has at least one of the following properties:
   (1) electrical breakdown strength of at least 177 kV/cm;
   (2) thermal capability exceeding the standards for NEMA Class F (155°C) and NEMA Class H (180°C) insulation, and has 5 or less wt.% gain due to water saturation at 100% Relative Humidity;
   (3) tear strength, measured as Elmendorf tear strength of at least 85 mN; and
   (4) resistivity of at least 1,000 MOhm-cm. Alternatively, the electrical breakdown strength in this embodiment may be 197, 216, 236, 256, 276, 295, 315, 335, 354, 374, or greater than 394 kV/cm.
Embodiment 10: The fibrous substrate of any of the preceding Embodiments, wherein the polyimide fibers are staple fibers; the aromatic polyamide fibers are fibrids; and the liquid crystal polyester fibers are continuous fibers.
Embodiment 11: The fibrous substrate of any of the preceding Embodiments, wherein the polyimide fibers have a length of 4 to 8 mm, and a linear mass density of 1.5 to 5 dtex.
Embodiment 12: The fibrous substrate of any of the preceding Embodiments, wherein the aramide fibrids have a length greater than 0 to less than 0.3 mm, and a width greater than 0 to less than 0.3 mm, and a depth greater than 0 to less than 0.1 mm.
Embodiment 13: The fibrous substrate of any of the preceding Embodiments, wherein the liquid crystal polyester fibers have a length of 3 to 6 mm, and a linear mass density of 1.7 to 2.8 dtex.
Embodiment 14: The fibrous substrate of any of the preceding Embodiments, wherein the thickness of the substrate is more than 0 micrometers to 500 micrometers.
Embodiment 15: The fibrous substrate of any of the preceding Embodiments, wherein the thickness of the substrate is 25 micrometers to 200 micrometers.
Embodiment 16: The fibrous substrate of any of the preceding Embodiments, further comprising a thermosetting or thermoplastic polymer impregnated in the fibrous substrate.
Embodiment 17: An article comprising the fibrous substrate of any of the preceding Embodiments.
Embodiment 18: The article of Embodiment 17, wherein the article is a phase separator, primary insulation or secondary insulation in a motor, generator or transformer.
Embodiment 19: A process of preparing a fibrous substrate, comprising forming a layer from a slurry comprising a suspension solvent; and a fiber composition comprising a combination of 35 to 70 wt.% of polyimide fibers; at least 5 wt.% of aromatic polyamide fibers; and 5 to 30 wt.% of liquid crystal polymer fibers, wherein the wt.% of the fibers is based on the total weight of the fibers in the fiber composition; dewatering the layer; and consolidating the layer to form the fibrous substrate.
Embodiment 20: The process of Embodiment 19, wherein the consolidating is conducted on a static press.
Embodiment 21: The process of Embodiment 20, wherein the layer is exposed to subatmospheric pressure during at least a portion of the process.
Embodiment 22: The process of Embodiment 21, wherein the consolidating is conducted in a continuous roll press. In embodiments where the consolidating occurs in a continuous roll press (aka calendaring), the paper (fibrous substrate) is pre-heated, preferably immediately before the consolidating occurs.
Embodiment 23: The fibrous substrate produced by preceding Embodiments 19 to 22.
Embodiment 24: An article comprising the fibrous substrate of Embodiment 23.

## Claims

1. A fibrous substrate comprising a consolidated product of a fiber composition comprising, based on the total weight of fibers in the fiber composition:
35 to 70 wt.% of polyetherimide fibers having a polydispersity index of 2.2 to 2.5;
at least 5 wt.% of aromatic polyamide fibrids;
20 to 30 wt.% of liquid crystal polymer fibers,
each based on the total weight of the fibers in the fiber composition;
wherein the consolidated product has a thickness of more than 0 to less than 800 µm

2. The fibrous substrate of Claim 1, wherein the substrate comprises less than 10 wt.% of a polycarbonate fiber.

3. The fibrous substrate of Claim 1 or 2, wherein the fiber composition is 50 to 70 wt.% of polyimide fibers;
greater than 5 to 20 wt.% of aromatic polyamide fibrids; and
25 to 30 wt.% of liquid crystal polymer fibers.

4. The fibrous substrate of Claim 1 or 2, wherein the fiber composition is 60 to 70 wt.% of polyimide fibers;
greater than 5 to 20 wt.% of aromatic polyamide fibers; and
5 to 20 wt.% of liquid crystal polymer fibers.

5. The fibrous substrate of any of the preceding Claims , wherein the aromatic polyamide is an aromatic para-polyamide.

6. The fibrous substrate of any of the preceding Claims, wherein the aromatic polyamide is poly(p-phenylene terephthalamide), poly(p-phenylene terephthalamide-co-3'4'-oxydiphenylene terephthalamide), or a combination comprising at least one of the foregoing aramid.

7. The fibrous substrate of any of the preceding Claims, wherein the liquid crystal polyester is poly(4-hydroxybenzoic acid-co-6-hydroxy-2-naphthoic acid).

8. The fibrous substrate of any of the preceding Claims, wherein
the polyimide fibers are staple fibers;
the aromatic polyamide fibers are fibrids; and
the liquid crystal polyester fibers are continuous fibers.

9. The fibrous substrate of any of the preceding Claims, wherein the aramide fibrids have a length greater than 0 to less than 0.3 mm, and a width greater than 0 to less than 0.3 mm and a depth greater than 0 to less than 0.1 mm.

10. The fibrous substrate of any of the preceding Claims, wherein the liquid crystal polyester fibers have a length of 3 to 6 mm, and a linear mass density of 1.7 to 2.8 dtex.

11. An article comprising the fibrous substrate of any of the preceding Claims.

12. The article of Claim 11, wherein the article is a phase separator, primary insulation or secondary insulation in a motor, generator or transformer.

13. A process of preparing a fibrous substrate, comprising forming a layer from a slurry comprising:
a suspension solvent; and
a fiber composition comprising a combination of
35 to 70 wt.% polyetherimide fibers having a polydispersity index of 2.2 to 2.5;
at least 5 wt.% of aromatic polyamide fibers; and
5 to 30 wt.% of liquid crystal polymer fibers,
wherein the wt.% of the fibers is based on the total weight of the fibers in the fiber composition;
dewatering the layer; and
consolidating the layer to form the fibrous substrate.

## Patentansprüche

1. Fasersubstrat umfassend ein verfestigtes Produkt einer Faserzusammensetzung, die bezogen auf das Gesamtgewicht von Fasern in der Faserzusammensetzung Folgendes umfasst:
zu 35 bis 70 Gew.-% Polyetherimidfasern mit einem Polydispersitätsindex von 2,2 bis 2,5;
zu mindestens 5 Gew.-% aromatische Polyamidfibride;
zu 20 bis 30 Gew.-% Flüssigkristallpolymerfasern,
jeweils bezogen auf das Gesamtgewicht der Fasern in der Faserzusammensetzung;
wobei das verfestigte Produkt eine Dicke von über 0 bis unter 800 µm aufweist.

2. Fasersubstrat nach Anspruch 1, wobei das Substrat zu unter 10 Gew.-% eine Polycarbonatfaser umfasst.

3. Fasersubstrat nach Anspruch 1 oder 2, wobei die Faserzusammensetzung aus Folgendem besteht:
zu 50 bis 70 Gew.-% aus Polyimidfasern;
zu über 5 bis 20 Gew.-% aus aromatischen Polyamidfibriden; und
zu 25 bis 30 Gew.-% aus Flüssigkristallpolymerfasern.

4. Fasersubstrat nach Anspruch 1 oder 2, wobei die Faserzusammensetzung aus Folgendem besteht:
zu 60 bis 70 Gew.-% aus Polyimidfasern;
zu über 5 bis 20 Gew.-% aus aromatischen Polyamidfasern; und
zu 5 bis 20 Gew.-% aus Flüssigkristallpolymerfasern.

5. Fasersubstrat nach irgendeinem der vorangehenden Ansprüche, wobei das aromatische Polyamid ein aromatisches para-Polyamid ist.

6. Fasersubstrat nach irgendeinem der vorangehenden Ansprüche, wobei das aromatische Polyamid Poly(p-phenylenterephthalamid), Poly(p-phenylenterephthalamid-co-3'4'-oxydiphenylenterephthalamid) oder eine mindestens eines der vorangehenden Aramide umfassende Kombination ist.

7. Fasersubstrat nach irgendeinem der vorangehenden Ansprüche, wobei der Flüssigkristallpolyester Poly(4-hydroxybenzoesäure-co-6-hydroxy-2-naphthoesäure) ist.

8. Fasersubstrat nach irgendeinem der vorangehenden Ansprüche, wobei die Polyimidfasern Stapelfasern sind;
die aromatischen Polyamidfasern Fibride sind; und
die Flüssigkristallpolyesterfasern Endlosfasern sind.

9. Fasersubstrat nach irgendeinem der vorangehenden Ansprüche, wobei die Aramidfibride eine Länge von über 0 bis unter 0,3 mm und eine Breite von über 0 bis unter 0,3 mm und eine Tiefe von über 0 bis unter 0,1 mm aufweisen.

10. Fasersubstrat nach irgendeinem der vorangehenden Ansprüche, wobei die Flüssigkristallpolyesterfasern eine Länge von 3 bis 6 mm und eine lineare Massendichte von 1,7 bis 2,8 dtex aufweisen.

11. Artikel umfassend das Fasersubstrat nach irgendeinem der vorangehenden Ansprüche.

12. Artikel nach Anspruch 11, wobei der Artikel ein Phasentrenner, eine Primärisolierung oder eine Sekundärisolierung in einem Motor, Generator oder Transformator ist.

13. Verfahren zur Herstellung eines Fasersubstrats, umfassend das Bilden einer Schicht aus einer Aufschlämmung, die Folgendes umfasst:
ein Suspensions-Lösungsmittel; und
eine Faserzusammensetzung umfassend eine Kombination aus 35 bis 70 Gew.-% Polyetherimidfasern mit einem Polydispersitätsindex von 2,2 bis 2,5;
mindestens 5 Gew.-% aromatischen Polyamidfibriden; und
5 bis 30 Gew.-% Flüssigkristallpolymerfasern,
wobei die Gew.-% der Fasern auf das Gesamtgewicht der Fasern in der Faserzusammensetzung bezogen sind;
Entwässern der Schicht; und
Verfestigenlassen der Schicht, um das Fasersubstrat zu bilden.

## Revendications

1. Substrat fibreux comprenant un produit consolidé d'une composition de fibres comprenant, par rapport au poids total des fibres dans la composition de fibres :
35 à 70 % en poids de fibres de polyétherimide ayant un indice de polydispersité de 2,2 à 2,5 ;
au moins 5 % en poids de fibrides de polyamide aromatique ;
20 à 30 % en poids de fibres de polymère à cristaux liquides,
chacun par rapport au poids total des fibres dans la composition de fibres ;
dans lequel le produit consolidé a une épaisseur de plus de 0 à moins de 800 µm.

2. Substrat fibreux selon la revendication 1, dans lequel le substrat comprend moins de 10 % en poids d'une fibre de polycarbonate.

3. Substrat fibreux selon la revendication 1 ou 2, dans lequel la composition de fibres est
50 à 70 % en poids de fibres de polyimide ;
plus de 5 à 20 % en poids de fibrides de polyamide aromatique ; et
25 à 30 % en poids de fibres de polymère à cristaux liquides.

4. Substrat fibreux selon la revendication 1 ou 2, dans lequel la composition de fibres est
60 à 70 % en poids de fibres de polyimide ;
plus de 5 à 20 % en poids de fibres de polyamide aromatique ; et
5 à 20 % en poids de fibres de polymère à cristaux liquides.

5. Substrat fibreux selon l'une quelconque des revendications précédentes, dans lequel le polyamide aromatique est un para-polyamide aromatique.

6. Substrat fibreux selon l'une quelconque des revendications précédentes, dans lequel le polyamide aromatique est le poly(p-phénylène téréphtalamide), le poly(p-phénylène téréphtalamide-co-3'4'-oxydiphénylène téréphtalamide), ou une combinaison comprenant au moins l'un des aramides qui précèdent.

7. Substrat fibreux selon l'une quelconque des revendications précédentes, dans lequel le polyester à cristaux liquides est le poly(acide 4-hydroxybenzoïque-co-acide 6-hydroxy-2-naphthoïque).

8. Substrat fibreux selon l'une quelconque des revendications précédentes, dans lequel
les fibres de polyimide sont des fibres discontinues ;
les fibres de polyamide aromatique sont des fibrides ; et
les fibres de polyester à cristaux liquides sont des fibres continues.

9. Substrat fibreux selon l'une quelconque des revendications précédentes, dans lequel les fibrides d'aramide ont une longueur supérieure à 0 et inférieure à 0,3 mm, et une largeur supérieure à 0 et inférieure à 0,3 mm et une profondeur supérieure à 0 et inférieure à 0,1 mm.

10. Substrat fibreux selon l'une quelconque des revendications précédentes, dans lequel les fibres de polyester à cristaux liquides ont une longueur de 3 à 6 mm et une masse linéique de 1,7 à 2,8 dtex.

11. Article comprenant le substrat fibreux selon l'une quelconque des revendications précédentes.

12. Article selon la revendication 11, dans lequel l'article est un séparateur de phases, un isolant primaire ou un isolant secondaire dans un moteur, un générateur ou un transformateur.

13. Procédé de préparation d'un substrat fibreux, comprenant la formation d'une couche à partir d'une suspension épaisse comprenant :
un solvant de mise en suspension ; et
une composition de fibres comprenant une combinaison de
35 à 70 % en poids de fibres de polyétherimide ayant un indice de polydispersité de 2,2 à 2,5 ;
au moins 5 % en poids de fibres de polyamide aromatique ; et
5 à 30 % en poids de fibres de polymère à cristaux liquides,
dans laquelle le % en poids des fibres est fondé sur le poids total des fibres dans la composition de fibres ;
la déshydratation de la couche ; et
la consolidation de la couche pour former le substrat fibreux.
